# EUROPEAN PATENT SPECIFICATION

(11) **EP 0 354 457 B1**
(45) Date of publication and mention of the grant of the patent: **22.06.1994**
(21) Application number: 89114237.4
(22) Date of filing: 02.08.1989
(51) Int. Cl.: H01L 29/788, H01L 27/115, H01L 21/82, G11C 17/00

(54) **A bipolar field-effect electrically erasable programmable read only memory cell and method of manufacture**
Elektrisch löschbare und programmierbare Nurlese-Bipolar-Feldeffekt-Speicherzelle und Verfahren zu deren Herstellung
Cellule de mémoire morte bipolaire et à effet de champ électriquement effaçable et programmable et sa méthode de fabrication

(30) Priority: 08.08.1988 US 229940
(43) Date of publication of application: 14.02.1990
(73) Proprietor: NATIONAL SEMICONDUCTOR CORPORATION, Santa Clara California 95051-8090 (US)
(72) Inventor: Anand, Kranti Vijay, Sunnyvale, CA. 94087 (US)
(74) Representative: Sparing - Röhl - Henseler Patentanwälte

(56) References cited:
- EP-A- 0 044 384
- EP-A- 0 176 111
- FR-A- 2 633 777
- US-A- 4 019 197
- US-A- 4 035 820
- US-A- 4 288 863

## Description

Conventional programmable memory elements can be divided into two categories: MOS devices and bipolar devices. In the first category, a floating gate MOSFET is combined with other MOSFETS which act as the active sensing devices. The floating gate MOSFET is reprogrammable, but EEPROMS fabricated with MOS devices are inherently slow. In the second category, bipolar integrated circuit non-volatile memory cells are usually constructed using some variation of a fuse technology. That is, each possible current path through the device comprises a fuse which is selectively blown to provide a permanently programmed device. One disadvantage of this technology is that the circuits require a large current to blow the fuse. Bipolar integrated circuits also have the disadvantage that, since they are programmed by blowing fuses, they are not reprogrammable, and the devices cannot be test-programmed without destroying them for other purposes.

Unfortunately, significant structural differences exist between bipolar devices and MOS devices, precluding the techniques used for fabrication of one type of device from being used to fabricate the other type of device. For example, the thin gate oxide and interpoly oxide layers used in conventional floating gate MOS devices are subject to contamination and mechanical damage when formed by bipolar fabrication methods, and the performance of bipolar devices frequently suffers when subjected to MOS fabrication methods. Consequently, the combination of technologies has not been successfully realized.

An example of such a combined bipolar/MOS device, an electrically erasable memory device, is shown e.g. by Fig. 1 of EP-A-176 111.

The present invention is directed to a floating gate MOSFET memory device manufacturing method, as defined by patent claim 1. Unlike conventional floating gate memory MOSFETs, as disclosed by e.g. US-A-4,019,197 or US-A-4,288,863 the MOSFETs fabricated as set forth in patent claim 1 do not require an interpoly oxide separating the two layers of polysilicon but only one layer of polysilicon although made in a two-step-process. Thus, both the bipolar and MOS devices may be fabricated using a single polysilicon layer process which provides high yields. Additionally, despite the inclusion of an MOS device, the fabrication process according to the present invention does not compromise the performance of the bipolar devices.

In one embodiment of the present invention, the drain of an electrically erasable floating gate P-channel MOSFET device is connected to the base of an NPN transistor for forming an EEPROM cell. The device is read by sensing the current flowing through the bipolar device, but the device is written into and erased by applying appropriate voltages to the MOSFET. Since each cell is rarely written into (or erased), but read often, inclusion of the slower MOS device is quite acceptable.

Both devices are constructed on the same silicon substrate using a single fabrication process. The floating gate MOS transistor is constructed by doping spaced apart source and drain regions of the substrate to a first conductivity type. An opposite conductivity type channel region is disposed between the source region and the drain region. A first (control) gate region is formed in the silicon substrate horizontally spaced apart from the channel region. The first gate region is formed by doping semiconductor material to the same conductivity type as the source and drain regions. A polysilicon layer, disposed over a silicon dioxide layer, bridges the first gate region and the channel region for communicating an electrical potential from the first gate region to the channel region. The polysilicon layer thus serves as a second (floating) gate region and is controlled through the first gate region to selectively form a conductive channel between the source and drain regions. Although the resulting MOS device has a somewhat larger area than conventional floating gate MOS devices, the high integrity gate oxide used to isolate the floating gate from both the channel region and the control gate region eliminates the problem of integrity of the interpoly oxide in conventional MOS devices.

These and other features and advantages of the invention will become apparent to those skilled in the art upon a reading of the following detailed description of the invention, which should be taken in conjunction with the accompanying drawings.

Fig. 1 is a schematic of an electrically erasable floating gate MOSFET device, according to the invention, connected to a bipolar transistor.

Fig. 2 is a cross-sectional perspective view of a floating gate MOS transistor according to the present invention.

Figs. 3-13 illustrate the steps for forming a floating gate MOS transistor and bipolar transistor according to the present invention.

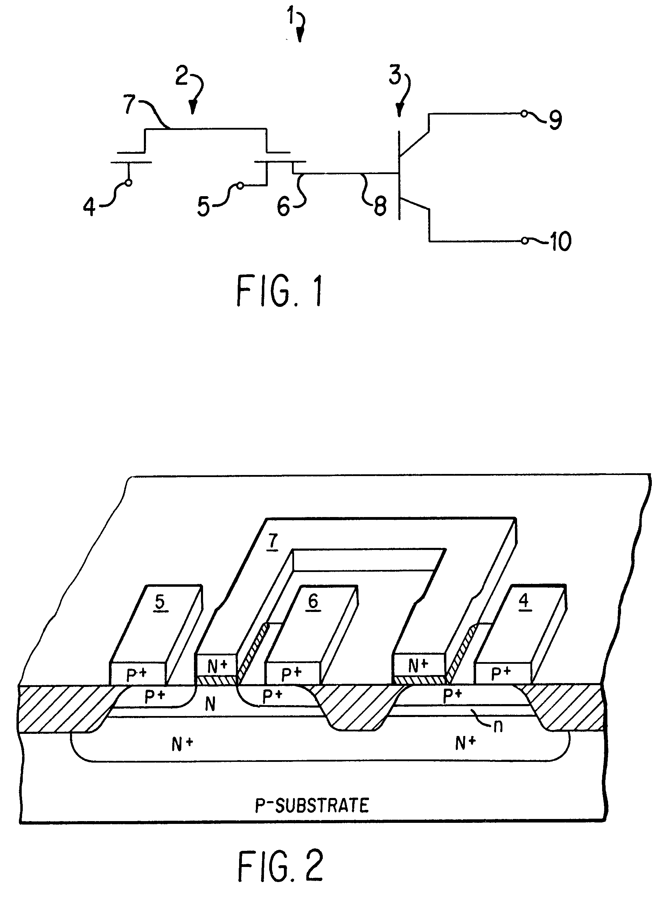

Fig. 1 is a schematic diagram of an electrically erasable programmable read only memory (EEPROM) cell 1 according to the present invention. EEPROM cell 1 comprises a P-channel floating gate MOSFET device 2 connected to a bipolar transistor 3. MOSFET 2 includes a control gate terminal 4, a source terminal 5, a drain terminal 6, and a floating gate 7. The drain terminal 6 of MOSFET 2 is connected to a base terminal 8 of bipolar transistor 3 for controlling the operation of bipolar transistor 3. Bipolar transistor 3 includes a collector terminal 9 and an emitter terminal 10.

For high speed, EEPROM cell 1 is read by sensing the collector/emitter current or impedance of bipolar transistor 3. On the other hand, when writing into or erasing the device, communication is with MOSFET 2. Since each cell is rarely written into (or erased), but read often, inclusion of the slower MOS device is quite acceptable. Preferably, avalanche injection, from either the source or the drain PN junction of MOSFET 2, is used for writing, and tunneling is used for erasing. That is, for writing into the device, a large programming voltage (e.g. approximately -10V) is applied to the drain terminal 6 of MOSFET 2, and a relatively small negative voltage (e.g. -2V) is applied to the control gate terminal 4. The voltage applied to control gate terminal 4 should be above the threshold value of the device. Under these conditions, MOSFET 2 is biased in a heavily conducting state with an electron-inversion layer carrying current from source to drain. When this electron flow enters and crosses the drain depletion layer, it encounters a very high electric field. A small fraction of the carriers gain enough energy from this field to overcome the oxide potential barrier at the silicon surface and drift to the floating gate. This injection builds up an excessive negative charge on the floating gate, forming the channel between the source and drain, and current continually flows from source to drain. Thus, when the device is written into, bipolar transistor 3 will be on, and collector terminal 9 and emitter terminal 10 of bipolar transistor 3 will be at a low impedence.

For erasing the device, a strong negative potential (e.g. -10V) is applied to control gate 4, and the source and drain terminals are maintained at approximately zero potential. This gives the electrons in the floating gate enough energy to overcome the potential barrier of the oxide surface and to drift back to the silicon substrate. Once erased, the excess electron density on the floating gate returns to zero, and no current flows from source to drain. Thus, in the erased state, bipolar transistor 3 will be off, and collector terminal 9 and emitter terminal 10 will be at a high impedence.

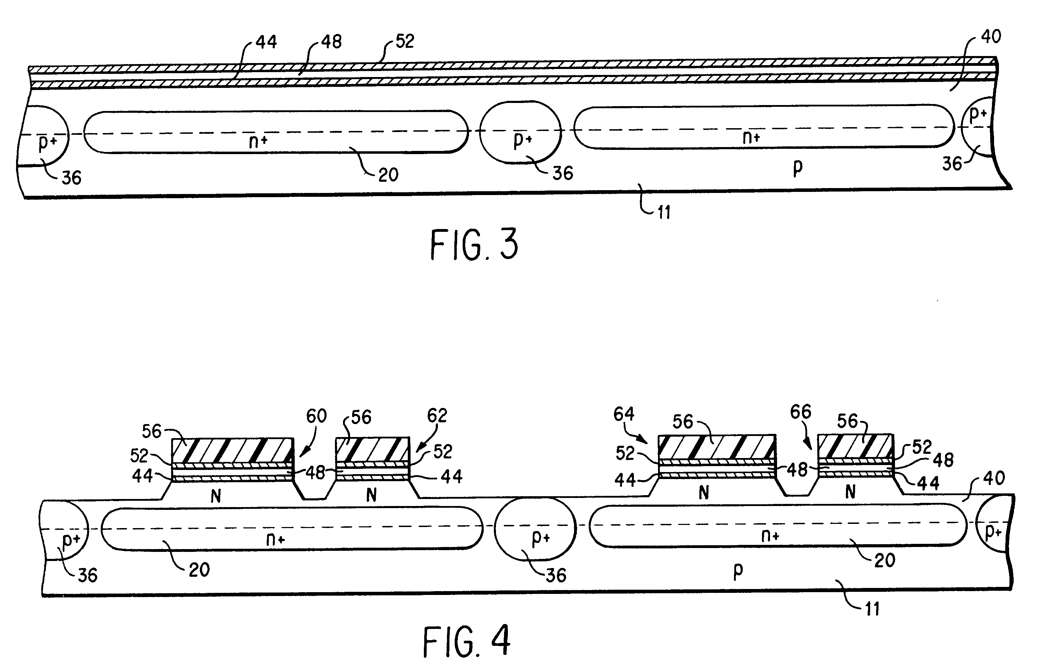

Fig. 2 is a cross-sectional perspective view of the floating gate MOSFET 2 showing the general structure of the device, with the numbering of components the same as in Fig. 1. The method of fabrication of MOSFET 2, together with bipolar device 3, shall now be described with reference to Figs. 3-13.

Fig. 3 shows a P-type silicon substrate 11 after having undergone preliminary processing according to conventional methods. First, substrate 11 is subjected to an initial oxidation step by being placed in a steam environment at about 1000°C for approximately 125 minutes to form an oxide layer (not shown) having a thickness of approximately 605 nm (6050 angstroms). A layer of photoresist is deposited and developed according to well known photolithographic techniques to define openings where buried layer 20 will be formed. The oxide is removed by a combination of wet and dry etching to expose substrate 11. The photoresist layer is removed, and the exposed portions of the substrate are reoxidized in steam at about 850°C for approximately 20 minutes to form an oxide layer of approximately 30 nm (300 Angstroms) thick. The buried N-type layers then are implanted with arsenic, at an implantation energy of approximately 80 KeV to a dose of approximately 5x10¹⁵ atoms/cm². Next, substrate 11 is placed in an oxidizing environment at 1100°C for approximately 60 minutes to anneal the implant and to form N+ regions 20, which will constitute conventional buried layers for the devices to be formed.

The oxide layer is removed and reformed. Another photoresist layer then is deposited and developed to form openings for the P-type regions 36. This area is ion-implanted with boron to form P+ implant regions.

Next, the photoresist is removed, and substrate 11 is annealed to convert the P+ implant regions into P+ field regions 36. The oxide layer is removed, and an N-type epitaxial silicon layer 40 grown by an LPCVD technique. In the preferred embodiment, expitaxial layer 40 has a thickness of approximately 1.3»m. Then, as shown in Fig. 3, substrate 11 is placed in an oxygen or steam environment at approximately 1000°C to form oxide layer 44, approximately 20 nm (200 angstroms) thick, and to anneal epitaxial layer 40. Thereafter, a silicon nitride layer 48 is deposited by CVD to a thickness of approximately 150 nm (1500 angstroms), and a layer of silicon dioxide 52 is formed over silicon nitride layer 48.

Next, as shown in Fig. 4, a photoresist layer 56 is deposited and developed for leaving the pattern shown. The exposed regions of silicon dioxide layer 52, silicon nitride layer 48, and silicon dioxide layer 44 not covered by photoresist layer 56 are etched. Then, using potassium hydroxide, the epitaxial layer 40 is etched to form islands 60, 62, 64, and 66. Islands 60 and 62 will be used to form bipolar transistor 3, and islands 64 and 66 will be used to form MOSFET 2.

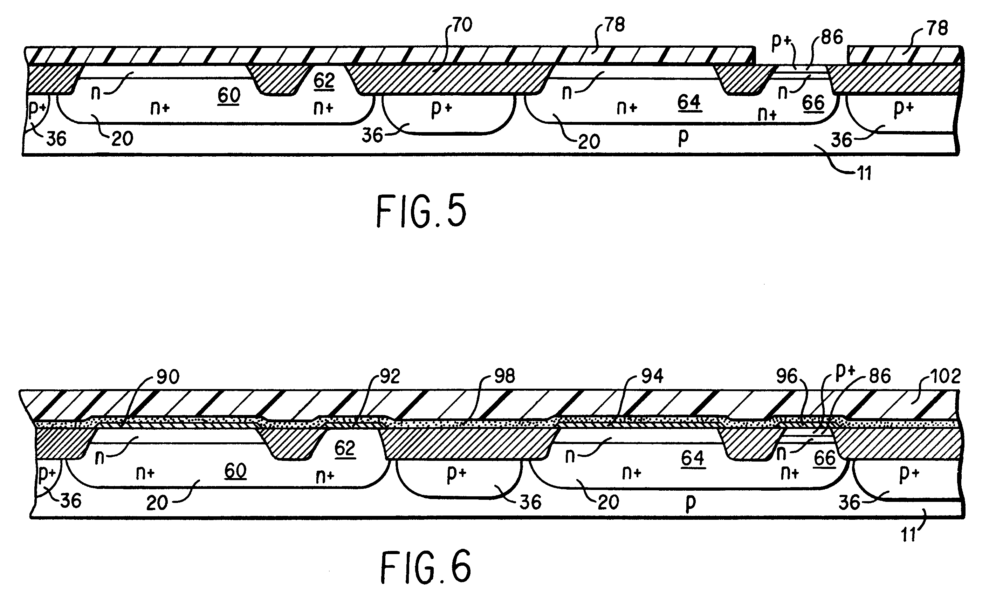

The remaining portions of photoresist layer 56 and silicon dioxide layer 52 are removed. The substrate 11 then is subjected to a high-pressure oxidation to form an oxide layer 70 to a depth of approximately 1000 nm (10,000 angstroms) for surrounding islands 60, 62, 64, and 66 (see Fig. 5). Then, nitride layer 48 is removed by etching, and oxide layer 70 is planarized using well-known techniques to expose the upper surfaces of islands 60, 62, 64, and 66.

As shown in Fig. 5, a photoresist layer is deposited and developed to expose island 62. Then, the collector sink is implanted with phosphorous at an implantation energy of approximately 190 KeV to a dose of approximately 2x10¹⁵ atoms/cm². The sink implant then is annealed at a temperature of 1000°C for approximately 60 minutes. At the completion of the process, an N+ collector sink region is formed.

The photoresist layer is removed, and a new photoresist layer 78 is deposited and developed to expose island 66. A P-type ion implant then is performed with boron at an implantation energy of approximately 40 KeV to a dose of approximately 6x10¹⁴ atoms/cm². This forms a P+ control gate region 86 in island 66. Thereafter, the remaining portions of photoresist layer 78 are removed.

Next, as shown in Fig. 6, a thin gate oxide layer, designated 90, 92, 94, and 96, is grown to a thickness of approximately 15 nm (150 angstroms) over islands 60, 62, 64, and 66, respectively. Over the gate oxide, a thin polysilicon layer 98 is deposited by CVD to a thickness of approximately 50 nm (500 angstroms). Finally, a photoresist layer 102 is deposited over polysilicon layer 98.

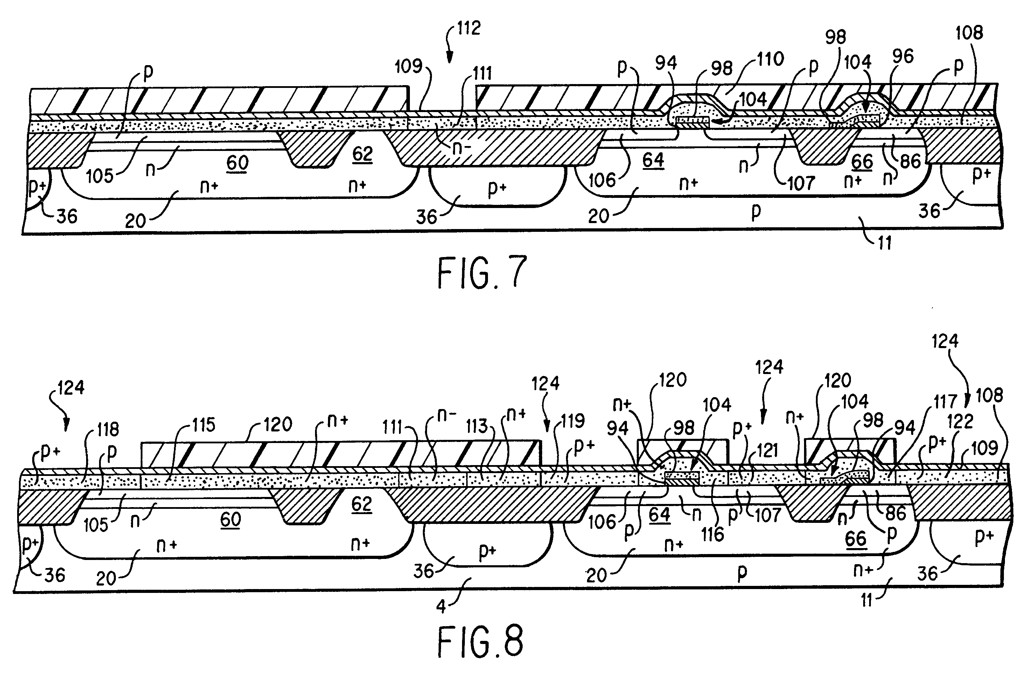

The photoresist layer 102 is exposed and developed to leave portions of photoresist over the areas which will form a single layer polysilicon floating gate 104. Then, polysilicon layer 98 and gate oxide layers 90, 92, 94, and 96 are etched to form part of polysilicon floating gate 104 (see Fig. 7). Although floating gate 104 is shown in Fig. 7 as two separated regions in cross-section, it is actually a continuous layer, as shown in Fig. 2. An unmasked base implant is then performed with boron at an implantation energy of approximately 40 KeV to a dose of approximately 8x10¹² atoms/cm². This forms a P-type base region 105 in island 60, and P-type source and drain regions 106 and 107, respectively, in island 64. Not enough P-type impurity is employed to over-compensate the doping of region 62 and, accordingly, it remains doped as an N-type region. Then, photoresist layer 102 is removed.

Next, as shown in Fig. 7, a thick polysilicon layer 108 is deposited by CVD to a thickness of approximately 450 nm (4500 angstroms), and a thin silicon dioxide layer 109 is formed over polysilicon layer 108. Polysilicon layers 98 and 108 may be considered as first and second sublayers of a larger, single polysilicon layer. Afterward, a photoresist mask 110 is deposited and developed to form an opening 112 over silicon dioxide layer 109 and polysilicon layer 108, where an N- polysilicon region 111 is to be formed. The polysilicon is then implanted with arsenic at an implantation energy of 100 KeV to a dose of approximately 2x10¹⁵ atoms/cm², and the remaining portions of photoresist layer 110 are removed. The N-region 111 may function as a high value resistor in the completed device.

A photoresist mask is deposited and developed to form openings over silicon dioxide layer 109 and polysilicon layer 108, where N+ polysilicon regions 113, 115, 116, and 117 are to be formed. Thereafter, substrate 11 is subjected to an N+ ion implant with arsenic at an implantation energy of 100 KeV to a dose of approximately 1x10¹⁶ atoms/cm², and the remaining portions of the photoresist layer are removed. N+ region 113 may serve as a low value resistor or as an ohmic contact to N- region 111, N+ region 115 will serve as the emitter/emitter contact and collection contact in the completed device, whereas N+ regions 116 and 117 will form the remaining part of floating gate 104.

Next, as shown in Fig. 8, a photoresist layer 120 is deposited and patterned to form openings 124 over silicon dioxide layer 109 and polysilicon layer 108, where P+ polysilicon regions 118, 119, 121 and 122 are to be formed. Then, substrate 11 is implanted with boron at an implantation energy of 100 KeV to a dose of approximately 1x10¹⁵ atoms/cm², and the remaining portions of photoresist layer 120 are removed. P+ region 118 will serve as the extrinsic base contact, P+ regions 119 and 121 will serve a the source and drain contacts, respectively, and P+ region 122 will serve as the control gate contact in the completed device.

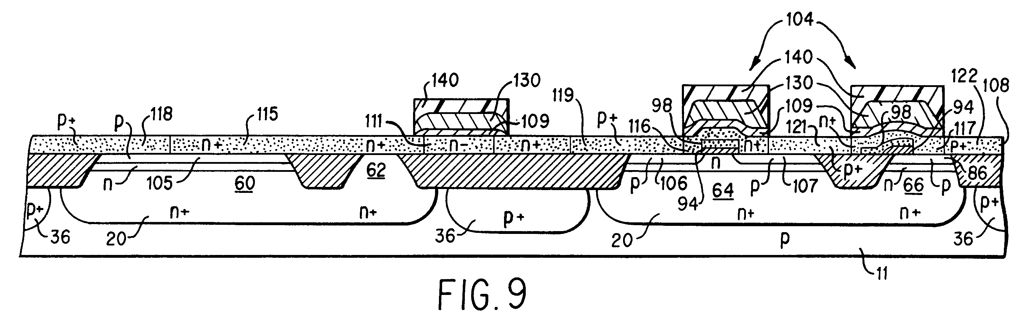

Next, as shown in Fig. 9, a silicon dioxide layer 130 is deposited over silicon dioxide layer 109 by LTO deposition. Substrate then is placed in an oxidizing environment at 800-900°C for annealing the previous P+, N- and N+ implants. A layer of photoresist 140 then is deposited and developed for covering the area over polysilicon floating gate 104 and N-region 111. This photoresist mask prevents silicide formation over floating gate 104 and N-region 111 in a later step. The exposed portions of silicon dioxide layers 130 and 109 then are etched to the polysilicon layer 108 as shown, and thereafter the remaining portions of photoresist layer 140 are removed.

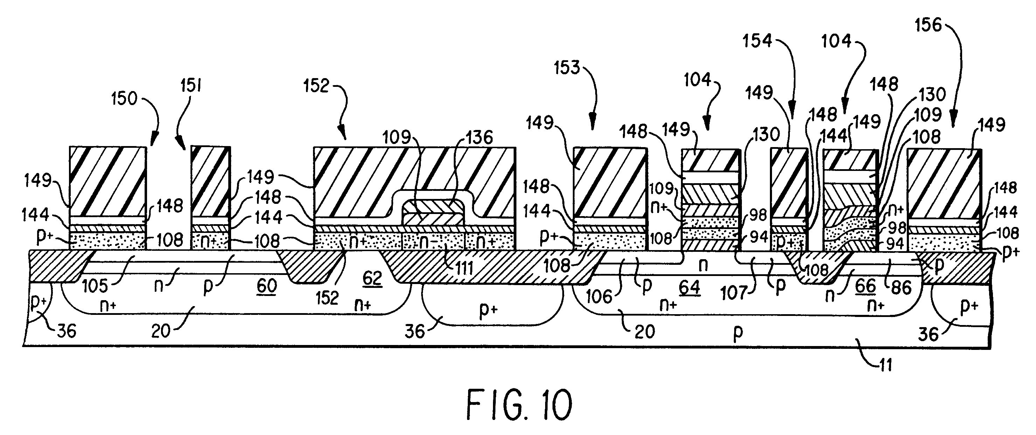

As shown by Fig. 10, Substrate 11 is placed in an oxygen or steam environment for forming a silicon dioxide layer 144 approximately 25 nm (250 angstroms) thick over the exposed portions of polysilicon layer 108. Then, a silicon nitride layer 148 is deposited by CVD as a blanket coating over the structure.

Another photoresist layer 149 is deposited and developed as shown. The portions of photoresist layer 149 remaining define the regions of polysilicon layer 108 where a base contact 150, an emitter contact 151, a collector contact 152, a source contact 153, a drain contact 154, and a control gate contact 156 are to be made to substrate 11. Floating gate 104 also is covered by photoresist layer 149. Thereafter, silicon nitride layer 148, oxide layer 144, and polysilicon layer 108 are etched to leave the portions of these layers shown.

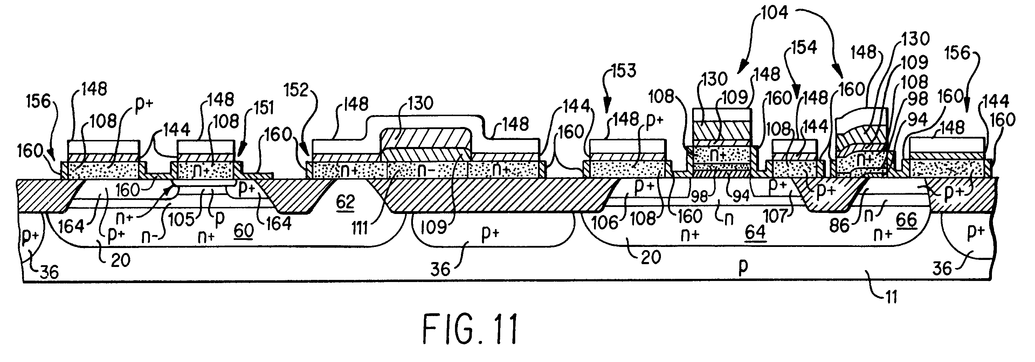

As shown in Fig. 11, the remaining portions of photoresist layer 149 then are removed, and the structure is placed in an oxygen or steam environment for forming an oxide layer 160 having a thickness of approximately 100 nm (1000 angstroms) over the exposed portions of polysilicon layer 108 and the exposed portions of islands 60, 62, 64, and 66. Next, the extrinsic base is implanted with boron difluoride at an implantation energy of approximately 40 KeV to a dose of approximately 4x10¹⁴ atoms/cm². Thereafter, the structure is subjected to a final implant anneal by placing it in an oxidizing environment at 950°C for approximately 30 minutes. This anneals P+ regions 164 in island 60. This also anneals source region 106, drain region 107, and control gate region 86.

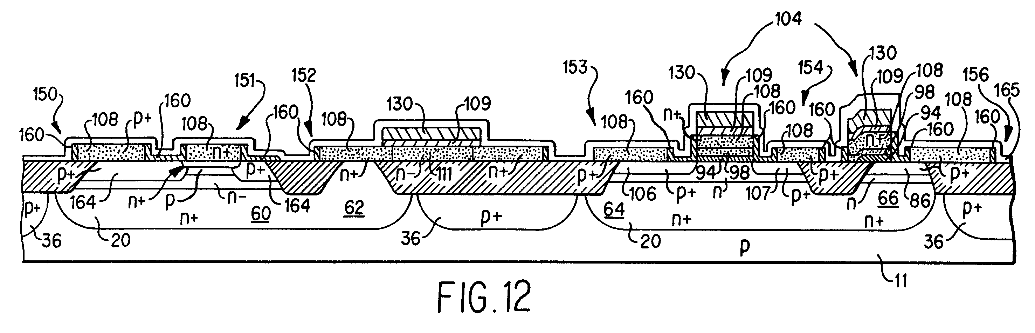

As shown in Fig. 12, the remaining portions of silicon nitride layer 148 and oxide layer 144 are then removed to expose polysilicon layer 108 in base contact 150, emitter contact 151, collector contact 152, source polycontact 153, drain polycontact 154, and control gate polycontact 156. Simultaneously, the thick oxide layer 130, disposed over floating gate 104, is etched to some degree but not completely removed.

Then, as shown further in Fig. 12, a titanium layer 165 is sputtered over the entire structure, and the structure is placed in a rapid thermal annealer to cause titanium layer 165 to react with underlying silicon to form a silicide on the base contact 150, emitter contact 151, and collector contact 152, as well as the source contact 153, drain contact 154, and control gate contact 156. Because of the oxide layers 130 and 109 disposed over floating gate 104 and N-region 111, no silicide reaction occurs there.

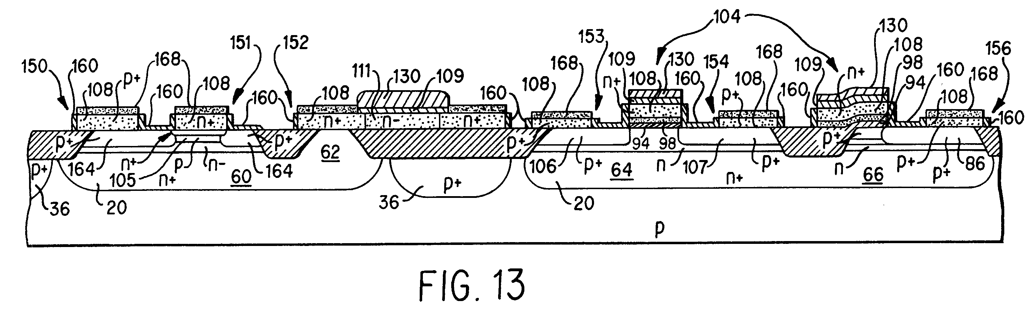

Finally, as shown in Fig. 13, the excess titanium layer 164 is removed by a wet chemical reaction, and the structure is again heat-pulsed for creating a second and final silicide reaction for forming the final silicide layers 168 over base contact 150, emitter contact 151, collector contact 152, source contact 153, drain contact 154, and control gate contact 156. The structure then may be completed using well known contact, metallization, and packaging techniques.

While the foregoing has been a complete description of a preferred embodiment of the present invention, various modifications may be employed. For example, MOSFET 2 may be fabricated alone by omitting those steps unique to bipolar transistor 3. Additionally, MOSFET 2 may be coupled to any number of bipolar or MOS elements, as desired. Consequently, the scope of the invention may be ascertained from the following claims.

## Claims

1. A method of making a floating gate electrically erasable MOS transistor,
said MOS transistor comprising a silicon substrate, including source and drain regions (106, 107) formed of a semiconductor material having one conductivity type and a channel region formed of a semiconductor material having a conductivity type opposite the conductivity type of the semiconductor material forming the source and drain regions, the channel region being disposed between and contacting the source and drain regions, the method comprising the steps of:
forming a control gate region (86) in the substrate generally coplanar with and spaced apart from the channel region, the source region, and the drain region (106, 107),
growing a layer (94) of silicon dioxide over the channel region and the gate region;
blanket depositing a first polysilicon layer (98) over the substrate;
etching the first polysilicon layer and the silicon dioxide layer from the substrate except for a continuous portion (104) of the first polysilicon layer extending from the control gate region to the channel region;
blanket depositing a second polysilicon layer (108) over the substrate;
etching the second polysilicon layer from the substrate except for a continuous portion of the second polysilicon layer extending from the control gate region to the channel region over the first polysilicon layer; and
wherein the continuous portion of the first polysilicon layer and the continuous portion of the second polysilicon layer define a floating gate.

2. The method of claim 1 wherein the first gate region (86) is made co-planar with the channel region.

3. The method of claim 2 wherein the silicon dioxide layer (94) contacts the first polysilicon layer (98), the control gate region (86), and the channel region.

4. The method of claim 3 wherein the control gate region (86) is formed of a semiconductor material having the same conductivity type (p) as the semiconductor material forming the source and drain regions (106, 107).

5. The method of claim 1, further comprising the step of:
partially covering the control gate region with said continuous portion (104).

6. The method of claim 5, further comprising the step of:
completely covering the channel region with said continuous portion (104).

7. The method of claim 6, further comprising the step of:
etching the second polysilicon layer (108) for forming a polysilicon contact (117) separated from said continuous portion and contacting the control gate region (86).

8. The method of claim 1 wherein the first polysilicon layer depositing step comprises the step of:
depositing said first polysilicon layer to a thickness of approximately 50 nm (500 angstroms); and
wherein said second polysilicon layer is deposited to a thickness of approximately 450 nm (4500 angstroms) over the first polysilicon layer.

## Patentansprüche

1. Ein Verfahren zum Herstellen eines elektrisch löschbaren MOS-Transistors mit schwimmendem Gate,
welcher MOS-Transistor ein Siliciumsubstrat mit Source- und Drainbereichen (106, 107) umfaßt, ausgebildet aus einem Halbleitermaterial mit einem Leitfähigkeitstyp, und einem Kanalbereich, ausgebildet aus einem Halbleitermaterial mit einem Leitfähigkeitstyp entgegengesetzt dem Leitfähigkeitstyp des Halbleitermaterials, aus dem Source- und Drainbereiche gebildet sind, welcher Kanalbereich zwischen den Source- und Drainbereichen angeordnet ist und mit diesen in Kontakt steht, welches Verfahren die Schritte umfaßt:
Bilden eines Steuer-Gate-Bereichs (86) in dem Substrat generell koplanar mit und im Abstand von dem Kanalbereich, dem Sourcebereich und dem Drainbereich (106, 107);
Aufwachsenlassen einer Schicht (94) aus Siliciumdioxid über dem Kanalbereich und dem Gatebereich;
maskenloses Aufbringen einer ersten Polysiliciumschicht (98) über dem Substrat;
Ätzen der ersten Polysiliciumschicht und der Siliciumdioxidschicht von dem Substrat mit Ausnahme eines kontinuierlichen Abschnitts (104) der ersten Polysiliciumschicht, der sich von dem Steuer-Gate-Bereich zu dem Kanalbereich erstreckt;
maskenloses Aufbringen einer zweiten Polysiliciumschicht (108) über dem Substrat;
Ätzen der zweiten Polysiliciumschicht von dem Substrat mit Ausnahme eines kontinuierlichen Abschnitts der zweiten Polysiliciumschicht, die sich von dem Steuer-Gate-Bereich zu dem Kanalbereich über der ersten Polysiliciumschicht erstreckt; und
bei welchem Verfahren der kontinuierliche Abschnitt der ersten Polysiliciumschicht und der kontinuierliche Abschnitt der zweiten Polysiliciumschicht ein schwimmendes Gate definieren.

2. Das Verfahren nach Anspruch 1, bei dem der erste Gatebereich (86) koplanar mit dem Kanalbereich hergestellt wird.

3. Das Verfahren nach Anspruch 2, bei dem die Siliciumdioxidschicht (94) die erste Polysiliciumschicht (98), den Steuer-Gate-Bereich (86) und den Kanalbereich kontaktiert.

4. Das Verfahren nach Anspruch 3, bei dem der Steuer-Gate-Bereich (86) aus einem Halbleitermaterial hergestellt ist, das denselben Leitfähigkeitstyp (p) wie das Halbleitermaterial, aus dem Source- und Drainbereiche (106, 107) gebildet sind, hat.

5. Das Verfahren nach Anspruch 1, ferner umfassen den Schritt:
teilweises Abdecken des Steuer-Gate-Bereichs mit dem kontinuierlichen Abschnitt (104).

6. Das Verfahren nach Anspruch 5, ferner umfassend den Schritt:
vollständiges Abdecken des Kanalbereichs mit dem kontinuierlichen Abschnitt (104).

7. Das Verfahren nach Anspruch 6, ferner umfassend den Schritt:
Ätzen der zweiten Polysiliciumschicht (108) für die Bildung eines Polysiliciumkontakts (117), der von dem kontinuierlichen Abschnitt getrennt ist und den Steuer-Gate-Bereich (86) kontaktiert.

8. Das Verfahren nach Anspruch 1, bei dem der erste Polysiliciumschichtaufbringschritt den Schritt umfaßt:
Aufbringen der ersten Polysiliciumschicht bis zu einer Dicke von etwa 50 nm (500 Å); und
bei dem die zweite Polysiliciumschicht bis zu einer Dicke von etwa 450 nm (4500 Å) über der ersten Polysiliciumschicht aufgebracht wird.

## Revendications

1. Procédé pour la réalisation d'un transistor MOS effaçable de façon électrique à grille flottante,
ledit transistor MOS comprenant un substrat en silicium, comprenant des régions de source et de drain (106, 107) formées d'un matériau semiconducteur ayant un type de conductivité et une région de canal formée d'un matériau semiconducteur ayant un type de conductivité opposé au type de conductivité du matériau semiconducteur formant les régions de source et de drain, la région de canal étant disposée entre les régions de source et de drain et étant en contact avec ces dernières, le procédé comprenant les étapes consistant à :
former une région de grille de commande (86) dans le substrat généralement coplanaire avec la région de canal, la région de source et avec la région de drain (106, 107) et espacée de ces dernières;
faire croître une couche (94) de dioxyde de silicium sur la région de canal et sur la région de grille;
déposer une première couche de polysilicium (98) sur tout le substrat;
graver la première couche de polysilicium et la couche de dioxyde de silicium à partir du substrat à l'exception d'une partie continue (104) de la première couche de polysilicium s'étendant de la région de grille de commande jusqu'à la région de canal;
déposer une deuxième couche de polysilicium (108) sur tout le substrat;
graver la deuxième couche de polysilicium à partir du substrat à l'exception d'une partie continue de la deuxième couche de polysilicium s'étendant de la région de grille de commande jusqu'à la région de canal sur la première couche de polysilicium; et
dans lequel la partie continue de la première couche de polysilicium et la partie continue de la deuxième couche de polysilicium définissent une grille flottante.

2. Procédé selon la revendication 1 dans lequel la première région de grille (86) est réalisée de façon coplanaire avec la région de canal.

3. Procédé selon la revendication 2 dans lequel la couche de dioxyde de silicium (94) est en contact avec la première couche de polysilicium (98), la région de grille de commande (86) et avec la région de canal.

4. Procédé selon la revendication 5 dans lequel la région de grille de commande (86) est formée d'un matériau semiconducteur ayant le même type de conductivité (P) que le matériau semiconducteur formant les régions de source et de drain (106, 107).

5. Procédé selon la revendication 1 comprenant en outre l'étape consistant à :
couvrir partiellement la région de grille de commande avec ladite partie continue (104).

6. Procédé selon la revendication 5 comprenant en outre l'étape consistant à :
couvrir complètement la région de canal avec ladite partie continue (104).

7. Procédé selon la revendication 6 comprenant en outre l'étape consistant à :
graver la deuxième couche de polysilicium (108) pour former un contact de polysilicium (117) séparé de ladite partie continue et en contact avec la région de grille de commande (86).

8. Procédé selon la revendication 1 dans lequel l'étape de dépôt de la première couche de polysilicium consiste à :
déposer ladite première couche de polysilicium jusqu'à obtenir une épaisseur d'approximativement 50 nm (500 angströms); et
dans lequel ladite deuxième couche de polysilicium est déposée jusqu'à obtenir une couche d'approximativement 450 nm (4500 angströms) sur la première couche de polysilicium.
